# NEUE EUROPÄISCHE PATENTSCHRIFT

(11) **EP 0 721 262 B2**
(45) Veröffentlichungstag und Bekanntmachung des Hinweises auf die Entscheidung über den Einspruch: **28.11.2007**
(45) Hinweis auf die Patenterteilung: 26.03.2003
(21) Anmeldenummer: 95117935.7
(22) Anmeldetag: 14.11.1995
(51) Int. Cl.: H04H 1/00, H04L 7/033

(54) **Verfahren und Vorrichtung zur Phasensynchronisation mit einem RDS-Signal**
Method and system for phase synchronisation with a radio data (RDS) signal
Méthode et dispositif de synchronisation en phase avec un signal RDS

(30) Priorität: 08.12.1994 DE 4443790
(43) Veröffentlichungstag der Anmeldung: 10.07.1996
(73) Patentinhaber: SGS-THOMSON MICROELECTRONICS GMBH, 85630 Grasbrunn (DE)
(72) Erfinder: Roither, Gerhard, D-81827 München (DE)
(74) Vertreter: Klunker . Schmitt-Nilson . Hirsch

(56) Entgegenhaltungen:
- EP-A- 0 272 938
- WO-A-93/17509
- US-A- 5 001 728
- EUROPEAN BROADCASTING UNION: "SPECIFICATIONS OF THE RADIO DATA SYSTEM RDS FOR VHF/FM SOUND BROADCASTING" März 1984 (1984-03) , EBU PUBLICATIONS, TECH. 3244-E , BRUSSELS, B. XP002113285 * Seite 40 - Seite 42 * * Abbildung 19 *

## Beschreibung

Die Erfindung betrifft ein Verfahren zur Phasensynchronisation eines in einem RDS-Empfänger erzeugten Bitratentaktsignals mit einem empfängerseitig demodulierten, digitalen RDS-Signal, wobei das Bitratentaktsignal und das RDS-Signal die gleiche Bitrate aufweisen.

Solch ein Verfahren ist aus den Dokumenten US 5 001 728 und WO 9 317 509 bekannt.

RDS ist die Abkürzung für Radia Data System. Dabei handelt es sich um ein im europäischen Raum genormtes System zur Übertragen von Rundfunksenderinformation an Rundfunkempfangsgeräte. Diese Rundfunksenderinformation, nachfolgend auch RDS-Information, überträgt in kodierter Weise den Namen oder einen Teil des Namens des RDS-Information aussendenden Rundfunksenders sowie die Angabe über weitere Frequenzen, über welche das Programm dieses Rundfunksenders ausgestrahlt wird. Mit Hilfe des RDS-Signals kann einerseits auf einer Anzeigevorrichtung eines RDS-tauglichen Rundfunkempfängers der Name des gerade empfangenen Senders angezeigt werden und kann andererseits von dem Rundfunkempfänger dann, wenn das Rundfunksignal des gerade empfangenen Rundfunksenders auf der gerade eingestellten Senderempfangsfrequenz nicht mehr mit ausreichender Qualität empfangen werden kann, automatisch auf eine andere Senderfrequenz, auf welcher dasselbe Programm desselben Senders gesendet wird, umgeschaltet werden.

Näheres über das RDS-System ist in der Druckschrift "Specifications of the Radio Data System RDS for VHF/FM Sound Broadcasting", Tech. 3244-E, Technical Center of the European Broadcasting Union Brussels, März 1984, beschrieben.

Die RDS-Daten sind einer Trägerfrequenz von 57 kHz mittels einer Biphasenmodulation aufmoduliert. Diese Trägerfrequenz wird nicht zum Empfänger übertragen. Da die RDS-Information in Form einer asynchronen Impulsfolge übertragen wird, muß die Trägerfrequenz von 57 kHz empfängerseitig erzeugt werden. Nach einer empfängerseitigen Synchrondemodulation mit Hilfe der empfängerseitig erzeugten 57 kHz Trägerfrequenz liegt die RDS-Information in Form eines digitalen Biphasensignals vor. Um die RDS-Daten empfängerseitig erhalten zu können, muß das Bitratentaktsignal empfängerseitig wiedergewonnen werden. Dafür wird gewöhnlich eine sogenannte Costas-Schaltung verwendet.

Jedes Bit des empfängerseitig demodulierten, digitalen RDS-Signals setzt sich aus zwei Halbbits zusammen, wobei zwischen dem ersten und dem zweiten Halbbit eines jedes RDS-Bits ein digitaler Übergang von 0 nach 1 oder von 1 nach 0 auftritt. In welcher Richtung der Übergang vom ersten zum zweiten Halbbit stattfindet, hängt davon ab, ob mit dem jeweiligen RDS-Bit der Logikwert "1" oder der Logikwert "0" übertragen werden soll. Am Übergang zwischen zwei benachbarten RDS-Bits tritt ein Übergang von 0 nach 1 oder von 1 nach 0 nur dann auf, wenn die benachbarten RDS-Bits den gleichen Logikwert übertragen. Übertragen benachbarte RDS-Bits unterschiedliche Logikwerte, findet zwischen ihnen kein Übergang von 0 nach 1 oder umgekehrt statt.

Damit die RDS-Information empfängerseitig sicher wiedergewonnen werden kann, müssen das empfängerseitig demodulierte, digitale RDS-Signal und das empfängerseitig erzeugte Bitratentaktsignal nicht nur die gleiche Bitrate haben sondern auch phasensynchron sein. Dies wird mittels einer PLL erwirkt. Nach dem Einschalten eines Rundfunkempfängers oder nach dessen Umschaltung auf eine andere als die bisher empfangene Senderempfangsfrequenz benötigt die PLL eine bestimmte Zeit zum Einrasten auf die neu empfangene Senderempfangsfrequenz, d.h., es dauert nach einem solchen Ein- oder Umschalten eine bestimmte Zeit, bis die Phasensynchronisation zwischen dem empfängerseitig demodulierten, digitalen RDS-Signal und dem empfängerseitig erzeugten Bitratentaktsignal hergestellt ist. Die Einrastzeit, innerhalb welcher eine solche Phasensynchronisation hergestellt wird, dauert in praktischen Fällen etwa 20 ms.

Die Qualität eines RDS-Demodulators hängt u.a. von der Einrastzeit ab. Man ist daher bestrebt, die Zeitdauer, bis nach einem Einschalt- oder einem Umschaltvorgang Phasensynchronisation hergestellt ist, so kurz wie möglich zu machen. Dies ist auch die Aufgabe der vorliegenden Erfindung.

Eine verfahrensmäßige Lösung dieser Aufgabe ist im Anspruch 1 angegeben und kann den Ansprüchen 2 bis 5 entsprechend weitergebildet werden. Eine vorrichtungsmäßige Lösung ist im Anspruch 6 angegeben und kann den Ansprüchen 7 bis 12 entsprechend weitergebildet werden. Die Erfindung umfaßt außerdem eine mit der erfindungsgemäßen Phasensynchronisationsvorrichtung ausgerüstete Bit-PLL für einen RDS-Empfänger, einen solchen RDS-Empfänger selbst und ein erfindungsgemäß arbeitendes RDS-Rundfunksystem.

Die erfindungsgemäße Lösung besteht darin, beim Einschalten des RDS-Empfängers oder bei dessen Umschalten auf eine andere als die bisher empfangene Senderempfangsfrequenz ein Steuersignal zu erzeugen, das beim Auftreten der nächsten Anstiegsflanke oder alternativ der nächsten Abfallflanke des RDS-Signals eine derartige Phasenwinkelverschiebung des Bitratentaktsignals bewirkt, daß das Bitratentaktsignal von da ab mit dem RDS-Signal phasensynchron ist.

Zur Erzeugung des Bitratentaktsignals wird ein empfängerseitig erzeugtes Oszillatorsignal, bei dem es sich vorzugsweise um das 57 kHz-Signal handelt, mittels eines Frequenzteilerzählers auf die Frequenz des Bitratentaktsignals herabgeteilt, wobei der Frequenzteilerzähler beim Auftreten der nächsten auf das Ein- bzw. das Umschalten des RDS-Empfängers folgenden Anstiegs- bzw. Abfallflanke des RDS-Signals vom Steuersignal auf einen vorbestimmten Zählwert gesetzt wird, bei dem das Bitratentaktsignal genauso eine Anstiegs- bzw. Abfallflanke wie das RDS-Signal aufweist.

Vorzugsweise wird die Flanke des RDS-Signals, bei welcher der Frequenzteilerzähler auf seinen vorbestimmten Zählwert gesetzt wird, mit einer entsprechend gerichteten Flanke des Oszillatorsignals synchronisiert. Das beim Ein- bzw. Umschalten des RDS-Empfängers erzeugte Steuersignal kann zwischengespeichert und durch das Auftreten der Anstiegs- bzw. der Abfallflanke des RDS-Signals zur Phasenwinkelverschiebung des Bitratentaktsignals freigegeben werden. Die Zwischenspeicherung des Steuersignals kann bei dem Vorgang der Phasenwinkelverschiebung des Bitratensignals wieder gelöscht werden. Bei einer bevorzugten Ausführungsform wird das Steuersignal bei der nächsten auf das Ein- oder Umschalten folgenden Abfallflanke des RDS-Signals erzeugt und wird der Frequenzteilerzähler infolge des Steuersignals auf seinen Anfangszählwert rückgesetzt, beispielsweise auf den Zählwert 0.

Dadurch, daß durch das Auftreten der auf das Einschalten oder Umschalten des RDS-Empfängers folgenden Anstiegs- bzw. Abfallflanke das Bitratentaktsignal schlagartig mit dem RDS-Signal phasensynchronisiert wird, geschieht das Einrasten der PLL beim Einschalten oder Umschalten schlagartig. Die Zeitdauer, die für das Erreichen der Phasensynchronisation benötigt wird, ist bei der erfindungsgemäßen Methode höchstens so lang wie die Dauer eines Halbbits. Das Bitratentaktsignal wird üblicherweise durch Freqzenzteilung des 57 kHz-Signals mit dem Teilungsfaktor 48 erhalten und weist daher eine Bitrate von 1187,5 Hz auf. Die Zeit, die mit der erfindungsgemäßen Methode bis zum Erhalt der Phasensynchronisation benötigt wird, ist daher höchstens etwa 0,4 ms und somit wesentlich kürzer als die bisher übliche Hinrastzeit von etwa 20 ms.

Die Erfindung wird nun anhand von Ausführungsformen näher erläutert. In der beiliegenden Zeichnung zeigen:
- **Fig. 1**: eine Darstellung des Bitratentaktsignals a und eines RDS-Bitsignals b;
- **Fig. 2**: ein Blockschaltbild einer erfindungsgemäßen Vorrichtung zur Phasensynchronisation; und
- **Fig. 3**: Signalverläufe, die an verschiedenen Stellen des in **Fig. 2** gezeigten Blockschaltbildes auftreten.

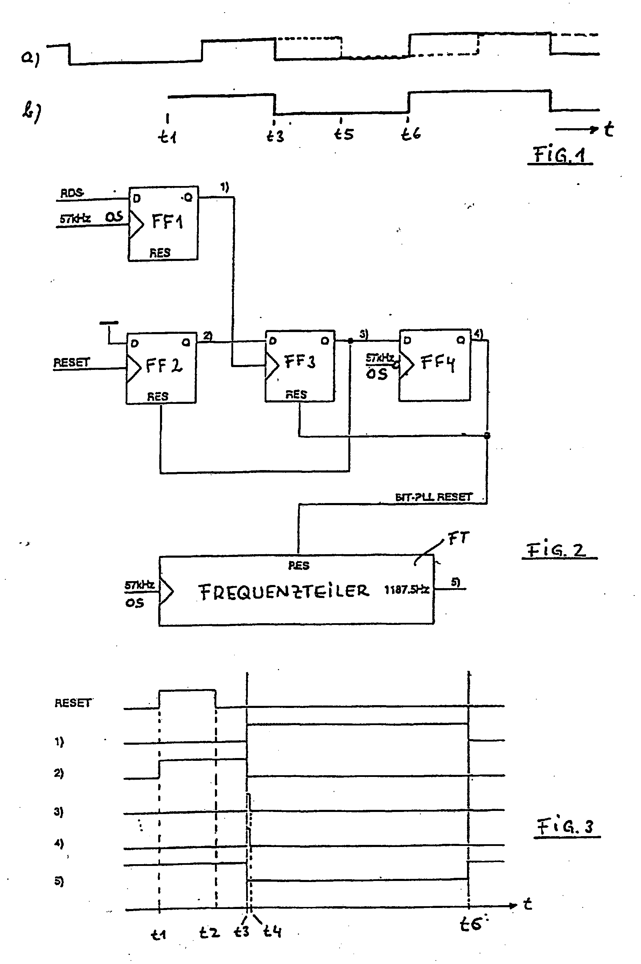

**Fig. 1** zeigt zwei Signalverläufe a und b. Signalverlauf a zeigt ein empfängerseitig erzeugtes Bitratentaktsignal. b zeigt ein emfängerseitig demoduliertes, digitales RDS-Signal. Zur Wiedergewinnung des RDS-Trägers, der nicht vom Sender zum Empfänger mitübertragen wird, wird empfängerseitig mit Hilfe eines Oszillators ein Oszillatorsignal OS von 57 kHz erzeugt. Durch Frequenzteilung mit einem Teilungsfaktor 48 wird daraus das Bitratentaktsignal mit einer Bitrate oder Impulsfrequenz von 1187,5 Hz erzeugt.

In **Fig. 1** ist angenommen, daß zur Zeit t1 der Empfänger eingeschaltet oder auf eine andere als die bisher empfangene Senderempfangsfrequenz umgeschaltet wird. Dieses Zeitpunkt t1 liegt im Zeitraum eines Halbbits des Bitratentaktsignals a mit niedrigem Signalwert. Das RDS-Signal b hat zur Zeit t1 einen hohen Signalwert.

Zum Zeitpunkt t3 weist das RDS-Signal einen 1-0-Übergang von einem hohen zu einem niedrigen Signalwert auf. Das Bitratentaktsignal a würde normalerweise gemäß der gestrichelten Darstellung erst zu einem Zeitpunkt t5 einen 1-0-Übergang von einem hohen zu einem niedrigen Signalwert aufweisen. Die Phasensynchronisation, die dann erreicht ist, wenn gleichgerichtete Signalwertübergänge von Bitratentaktsignal und RDS-Signal übereinstimmen, wird herkömmlicherweise dadurch bewirkt, daß eine PLL eine Phasenverschiebung erzeugt, bis die Phasensynchronisation erreicht ist.

Erfindungsgemäß wird dagegen zum Zeitpunkt t3, also zum Zeitpunkt des 1-0-Übergangs des RDS-Signals, das Bitratentaktsignal schlagartig um einen derartigen Phasenwinkel verschoben, das dessen nächster 1-0-Übergang mit abfallender Flanke, der eigentlich erst zum Zeitpunkt t5 fällig wäre, nun mit dem Zeitpunkt t3 zusammenfällt. Wenn dann das RDS-Signal b zum Zeitpunkt t6 seinen nächsten Flankenwechsel aufweist, tritt auch im Bitratentaktsignal a ein entsprechender Flankenwechsel auf, weil das RDS-Signal und das Bitratentaktsignal die gleiche Halbbitzeitdauer haben.

Die schlagartige Phasensynchronisation des Bitratentaktsignals mit dem RDS-Signal zum Zeitpunkt t3 wird bei einer bevorzugten Ausführungsform der Erfindung dadurch erreicht, daß ein Frequenzteilerzähler, mit dessen Hilfe das Bitratentaktsignal aus dem Oszillatorsignal OS erzeugt wird, beim Auftreten der abfallenden Flanke des RDS-Signals zum Zeitpunkt t3 schlagartig auf einen solchen Zählwert, vorzugsweise Anfangszählwert oder Zählwert 0, gesetzt wird, bei welchem am Ausgang des Frequenzteilerzählers die entsprechend Flanke des Bitratentaktsignals auftritt.

Man sieht aus **Fig. 1,** daß die Phasensynchronisation des Bitratentaktsignals mit dem RDS-Signal bei einem Ein- oder Umschalten des RDS-Empfängers praktisch schlagartig geschieht, nämlich innerhalb einer Zeitdauer, die höchstens solange dauert wie ein Halbbit.

Eine bevorzugte Ausführungsform einer erfindungsgemäßen Phasensynchronisationsvorrichtung ist in **Fig. 2** in Form eines Blockschaltbildes gezeigt. Dieses umfaßt vier D-Flipflops FF1 bis FF4 und einen Frequenzteiler FT.

Dem D-Eingang von FF1 wird das empfängerseitig demodulierte, digitale RDS-Signal zugeführt. Der Takteingang von FF1 wird mit dem 57 kHz-Oszillatorsignal OS beaufschlagt. Der Q-Ausgang von FF1 ist mit dem Takteingang von FF3 verbunden.

Der D-Eingang von FF2 liegt permanent auf Massepotential, also permanent auf niedrigem digitalen Signalwert. Der Takteingang von FF2 ist mit dem Ausgang einer (nicht gezeigten) Steuerschaltung verbunden, die beim Einschalten oder Umschalten des RDS-Empfängers auf eine andere als die bisher empfangene Senderempfangsfrequenz ein Steuersignal abgibt, das in **Fig. 2** mit RESET bezeichnet ist. Bei der Steuerschaltung handelt es sich vorzugsweise um einen Mikroprozessor, der auch die Steuerungen beim Einschalten des RDS-Empfängers bzw. dessen Umschalten auf eine andere Senderempfangsfrequenz vornimmt und daher "weiß", wann eine solche Ein- bzw. Umschaltung erfolgt und daher zum richtigen Zeitpunkt das Steuersignal RESET liefern kann.

Der D-Eingang von FF3 ist mit dem Q-Ausgang von FF2 verbunden. Wie bereits erwähnt, ist dessen Takteingang mit dem Q-Ausganng von FF1 verbunden. Der Q-Ausgang von FF3 ist einerseits mit einem Rücksetzeingang RES des FF2 und andererseits mit dem D-Eingang von FF4 verbunden. Am Takteingang von FF4 liegt das 57 kHz-Oszillatorsignal OS. Der Q-Ausgang von FF4 ist einerseits mit einem Rücksetzeingang RES von FF3 und andererseits mit einem Rücksetzeingang RES des Frequenzteilers FT verbunden.

An einem Zähltakteingang des Frequenzteilers FT liegt das 57 kHz-Oszillatorsignal OS an. Dieses wird vom Frequenzteiler FT auf das 1187,5 Hz-Bitratentaktsignal herabgeteilt, das am Ausgang des Frequenzteilers FT zur Verfügung steht.

Das D-Flipflop FF2 wirkt als Zwischenspeicher für das Steuersignal RESET. Dieses Steuersignal wird am Q-Ausgang von FF2 verfügbar gehalten, bis FF2 durch einen Signalwechsel am Q-Ausgang von FF3 rückgesetzt und damit die Zwischenspeicherung des Steuersignals RESET gelöscht wird. FF1 wirkt als Flankensynchronisierschaltung, mittels welcher die Flanken des RDS-Signals mit den Flanken des Oszillatorsignals OS synchronisiert werden. Das RDS-Signal ist danach hinsichtlich seiner Phasenlage mit dem internen System des RDS-Empfängers synchronisiert.

FF3 und FF4 wirken zusammen als eine Impulsformungsschaltung, die das am Q-Ausgang von FF3 auftretende Signal auf eine Zeitdauer begrenzt, die einer Halbperiode des 57 kHz-Oszillatorsignals OS entspricht. Eine Halbperiode des Oszillatorsignals OS nach dem Durchschalten der abfallenden Flanke des RDS-Signals auf den Q-Ausgang von FF3 erzeugt FF4 an seinem Q-Ausgang ein Rücksetzsignal, mittels welchem FF3 nach dieser Halbperiodendauer von OS wieder rückgesetzt wird. Damit wird sichergestellt, daß der Frequenzteiler FT an seinem Rücksetzeingang einen ausreichend kurzen Rücksetzimpuls erhält, damit die Rücksetzwirkung nur während einer Periode des dem Frequenzteiler FT zugeführten Oszillatorsignals OS anhält.

Die Arbeitsweise der in **Fig. 2** gezeigten Phasensynchronisationsvorrichtung wird nun noch etwas näher unter Zuhilfenahme der **Fig. 3** erläutert. **Fig. 3** zeigt Signalverläufe, die an verschiedenen Stellen der in **Fig. 2** gezeigten Schaltung auftreten. Wo die einzelnen Signalverläufe auftreten, ist durch gleichlautende Ziffern in den **Fig. 2 und 3** gezeigt.

Es sei wieder angenommen, daß zum Zeitpunkt t1 ein Einschalten des RDS-Empfängers oder dessen Umschaltung auf eine andere als die bisher empfangene Senderempfangsfrequenz erfolgt. Darauf hin erzeugt die dem Takteingang des Flipflops FF2 vorausgeschaltete Steuerschaltung das Steuersignal RESET. Dies führt zu einem Übergang des Q-Ausgangs von FF2 auf einen hohen digitalen Signalwert vom Zeitpunkt t1 ab. Dieser hohe Signalwert wird ab t1 dem D-Eingang von FF3 angeboten.

Zum Zeitpunkt t3 weist das mit dem Oszillatorsignal OS synchronisierte, vom Q-Ausgang von FF1 gelieferte RDS-Signal 1 einen Flankenanstieg von einem niedrigen zu einem hohen digitalen Signalwert auf. Diese Anstiegsflanke des synchronisierten RDS-Signals 1 bewirkt ein Durchschalten des am D-Eingang von FF3 anliegenden hohen Signalwerts zum Q-Ausgang von FF3. Das Signal 3 geht daher zum Zeitpunkt t3 auf einen hohen Signalwert über. Dies wiederum bewirkt einen Anstieg des Signals am Q-Ausgang von FF4 auf hohen Signalwert zum Zeitpunkt t3, wie der Signalverlauf 4 in **Fig. 3** zeigt. Das am Takteingang von FF4 anliegende Oszillatorsignal OS bewirkt, daß der Q-Ausgang von FF4 eine halbe Periodendauer des 57 kHz-Oszillatorsignals später wieder auf niedrigen Signalwert übergeht, wie der Signalverlauf 4 in **Fig. 3** zeigt. Die Abfallflanke am Q-Ausgang von FF4 setzt FF3 zurück, was einen Übergang der Signalverläufe 3 und 4 zum niedrigen Signalwert zum Zeitpunkt t4 zur Folge hat. Der vom Q-Ausgang von FF4 auf den Rücksetzeingang RES des Frequenzteilers FT gelieferte Rücksetzimpuls hat daher auch nur eine Länge entsprechend der halben Periodendauer des 57 kHz-Oszillatorsignals OS. Der Frequenzteiler FT wird daher zum Zeitpunkt t3 rückgesetzt und beginnt von da ab einen neuen Zähldurchgang, so daß das Bitratentaktsignal, das in **Fig. 3** als Signalverlauf 5 gezeigt ist, zum Zeitpunkt t3 einen Signalwechsel von hohem zu niedrigem Signalwert aufweist. Vom Zeitpunkt t3 ab ist daher das Bitratentaktsignal 5 mit dem RDS-Signal 1 phasensynchronisiert. Zum Zeitpunkt t6 tritt daher der nächste Flankenwechsel sowohl des RDS-Signals als auch des Bitratentaktsignals schon zum selben Zeitpunkt auf.

Wie der Signalverlauf RESET in **Fig. 3** zeigt, wird nach einem Ein- oder Umschalten des RDS-Empfängers das Steuersignal RESET von der Steuerschaltung nur für eine vorbestimmte Zeitdauer t1 bis t2 geliefert und nur einmal nach einem solchen Einschalt- oder Umschaltvorgang. Eine Rücksetzung des Frequenzteilers FT ist daher nach jedem Einschalt- oder Umschaltvorgang des RDS-Empfängers nur einmal möglich und nur während maximal einer Halbbitdauer des RDS-Signals. Denn spätestens dann ist das Zwischenspeicher-Flipflop FF2 wieder rückgesetzt und kann keine weitere Rücksetzung des Frequenzteilers FT mehr ausgelöst werden. Danach auftretende Störungen können sich somit nicht auswirken. Sollte eine Störung innerhalb dieser kurzen Zeit einer RDS-Halbbitdauer auftreten, die fälschlicherweise eine Übergangsflanke des RDS-Signals vortäuscht, geschieht nichts weiter als daß in diesem speziellen Fall nicht die schlagartige Phasensynchronisation des Bitratentaktsignals mit dem RDS-Signal gelingt sondern dann durch das herkömmliche PLL-Einrasten bewirkt wird.

Ob man für den erfindungsgemäßen Phasensynchronisationsvorgang die nächstauftretende ansteigende oder die nächstauftretende abfallende Übergangsflanke des RDS-Signals verwendet, ist ins Belieben gestellt.

Bei dem in **Fig. 1** gezeigten Beispiel ist davon ausgegangen, daß die nächste abfallende Übergangsflanke des RDS-Signals zur Phasensynchronisation herangezogen wird. Im Signalverlauf 1 der **Fig. 3** ist umgekehrt davon ausgegangen, daß zu der Phasensynchronisation die nächste ansteigende Übergangsflanke des RDS-Signals benutzt wird.

## Patentansprüche

1. Verfahren zur Phasensynchronisation eines in einem RDS-Empfänger erzeugten Bitratentaktsignals (5) mit einem empfängerseitig demodulierten, digitalen RDS-Signal (1), wobei das Bitratentaktsignal (5) und das RDS-Signal (1) die gleiche Bitrate aufweisen,
**dadurch gekennzeichnet,**
**dass** beim Einschalten des RDS-Empfängers oder bei dessen Umschalten auf eine andere als die bisher empfangene Senderempfangsfrequenz ein Steuersignal (RESET) erzeugt wird, das beim Auftreten der nächsten Anstiegsflanke oder alternativ der nächsten Abfallflanke des RDS-Signals (1) eine derartige Phasenwinkelverschlebung des Bitratentaktsignals (5) bewirkt, dass das Bitratentaktsignal (5) von da ab mit dem RDS-Signal (1) phasensynchron ist, und
**dass** zur Erzeugung des Bitratentaktsignals (5) ein empfängerseitig erzeugtes Oszillatorsignal (OS) mittels eines Frequenzteilerzählers (FT) auf die Frequenz des Bitratentaktsignals (5) herabgeteilt wird und dass der Frequenzteilerzähler (FT) beim Auftreten der nächsten auf das Ein- bzw, das Umschalten des RDS-Empfängers folgenden Anstiegs- bzw. Abfallflanke des RDS-Signals (1) vom Steuersignal (RESET) auf einen vorbestimmten Zählwert gesetzt wird, bei dem das Bitratentaktsignal (5) genauso eine Anstiegs- bzw. Abfallflanke wie das RDS-Signal (1) aufweist.

2. Verfahren nach Anspruch 1,
**dadurch gekennzeichnet,**
**dass** die Flanke des RDS-Signals (1), bei welcher der Frequenzteilerzähler (FT) auf seinen vorbestimmten Zählwert gesetzt wird, mit einer entsprechend gerichteten Flanke des Oszillatorsignals (OS) synchronisiert wird.

3. Verfahren nach einem der Ansprüche 1 bis 2,
**dadurch gekennzeichnet,**
**dass** das beim Ein- bzw. Umschalten des RDS-Empfängers erzeugte Steuersignal (RESET) zwischengespeichert und durch das Auftreten der Anstiegs- bzw. der Abfallflanke des RDS-Signals (1) zur Phasenwinkelverschiebung des Bitratentaktsignals (5) freigegeben wird.

4. Verfahren nach Anspruch 3,
**dadurch gekennzeichnet,**
**dass** die Zwischenspeicherung des Steuersignals (RESET) bei dem Vorgang der Phasenwinkelverschiebung des Bitratentaktsignals (5) gelöscht wird.

5. Verfahren nach einem der Ansprüche 1 bis 4,
**dadurch gekennzeichnet,**
**dass** das Steuersignal bei der nächsten auf das Ein- oder Umschalten folgenden Abfallflanke des RDS-Signals (1) erzeugt wird und dass der Frequenzteilerzähler (FT) von dein Steuersignal auf seinen Anfangszählwert rückgesetzt wird.

6. Vorrichtung zur Phasensynchronisation eines in einem RDS-Empfänger erzeugten Bitratentaktsignals (5) mit einem empfängerseitig demodulierten RDS-Signal (1), wobei das Bitratentaktsignal (5) und das RDS-Signal (1) die gleiche Bitrate aufweisen,
mit einem empfängerseitigen Oszillator zur Erzeugung eines Oszillatorsignals (OS) und mit einem Frequenzteilerzähler (FT), dem eingangsseitig das Oszillatorsignal (OS) zugeführt wird und dessen Ausgang das Bitratentaktsignal (5) liefert,
**dadurch gekennzeichnet,**
**dass** der Frequenzteilerzähler (FT) einen Zählerrücksetzeingang (RES) zum Rücksetzen auf einen Anfangszählwert aufweist,
**dass** eine Steuereinrichtung vorgesehen ist, mit der beim Einschalten des RDS-Empfängers oder bei dessen Umschalten auf eine andere als die bisher empfangene Senderempfangsfrequenz ein Steuersignal (RESET) erzeugbar ist,
**dass** ein Zwischenspeicher (FF2) vorgesehen ist, in dem das Steuersignal (RESET) zwischenspeicherbar ist und der einen Zwischenspeicherrücksetzeingang (RES) zum Löschen des Zwischenspeicherinhalts aufweist, und dass ein Flankendetektor (FF3) vorgesehen ist, der beim Auftreten der Anstiegs- bzw. der Abfallflanke des RDS-Slgnals (1) ein Flanicendetektionssignal (3) abgibt, das ein Auslesen des im Zwischenspeicher (FF2) gespeicherten Steuersignals (RESET) und dessen Übertragung an den Zählerrücksetzeingang (RES) und an den Zwischenspeicherrücksetzeingang (RES) verursacht.

7. Vorrichtung nach Anspruch 6,
**dadurch gekennzeichnet,**
**dass** eine Flankensynchronisierschaltung (FF1) vorgesehen ist, der eingangsseitig das Oszillatorsignal (OS) und das RDS-Signal zugeführt wird und die ausgangsseitig ein RDS-Signal (1) liefert, dessen das Rücksetzen des Frequenztellerzählers (FT) bewirkende Flanke mit einer gleichgerichteten Flanke des Oszillatorsignals (OS) synchronisiert ist,
und **dass** der Ausgang der Flankensynchronislerschaltung (FF1) mit einem Signaleingangsanschluss des Flankendetektors (FF3) verbunden ist.

8. Vorrichtung nach Anspruch 6 oder 7,
**dadurch gekennzeichnet,**
**dass** dein Flankendetektor (FF3) eine Impulsformungsschaltung (FF3, FF4) zugeordnet ist, mittels welcher das Ausgangssignal des Flankendetektors (FF3) in einen Flankendetektlonsimpuls geformt wird, dessen zeitliche Länge im Bereich der halben Periodendauer des Osziliatorsignals (OS) liegt.

9. Vorrichtung nach Anspruch 7 oder 8,
**dadurch gekennzeichnet,**
**dass** die Flankensynchronisierschaltung ein erstes D-Flipflop (FF1) aufweist, dessen D-Eingang das RDS-Signal zugeführt wird, dessen Takteingang mit dem Oszillatorsignal (OS) beaufschlagt wird und dessen Ausgang das mit dem Oszillatorsignal (OS) flankenmässig synchronisierte RDS-Signal (1) liefert.

10. Vorrichtung nach einem der Ansprüche 6 bis 9,
**dadurch gekennzeichnet,**
**dass** der Zwischenspeicher ein zweites D-Fllpflop (FF2) aufweist, dessen D-Eingang auf einem konstanten Logikwertpegel liegt, dessen Takteingang das Steuersignal (RESET) von der Steuereinrichtung zugeführt wird, dessen den Zwischenspeicherrücksetzeingang bildender Reset-Eingang mit dem Flankendetektionssignal des Flankendetektors (FF3) beaufschlagt wird und an dessen Ausgang das Steuersignal (RESET) vom Beginn seines Auftretens bis zum Erhalt des Flankendetektionssignals am Reset-Eingang auftritt.

11. Vorrichtung nach einem der Ansprüche 6 bis 10,
**dadurch gekennzeichnet,**
**dass** der Flankendetektor ein drittes D-Flipflop (FF3) aufweist, dessen D-Eingang mit dem Ausgang des zweiten D-Flipflop (FF2) verbunden ist, dessen Takteingang mit dem RDS-Signal, gegebenenfalls nach dessen Flankensynchronisation mit dein Oszillatorsignal (OS), beaufschlagt wird und dessen Ausgang einerseits mit dein Zwischenspeicherrücksetzeigang und andererseits mit dem Zählerrücksetzeingang verbunden ist.

12. Vorrichtung nach einem der Ansprüche 8 bis 11,
**dadurch gekennzeichnet,**
**dass** die Impulsformungsschaltung das dritte D-Flipflop (FF3) und ein viertes D-Flipflop (FF4) aufweist, wobei der D-Eingang des vierten D-Flipflop (FF4) mit dem Ausgang des dritten D-Flipflop (FF3) verbunden ist, der Takteingang des vierten D-Flipflop (FF4) mit dein Oszillatorsignal (OS) beaufschlagt wird und der Ausgang des vierten D-Flipflop (FF4) einerseits mit dem Reset-Eingang des dritten D-Flipflop (FF3) und andererseits mit dem Zählerrücksetzeingang verbunden ist.

13. Bit-PLL für einen RDS-Empfänger, **gekennzeichnet durch** eine Phasensynchronisationsvorrichtung nach einem der Ansprüche 6 bis 12.

14. RDS-Empfänger, **gekennzeichnet durch** eine Bit-PLL nach Anspruch 13.

15. RDS-Rundfunksystem mit mindestens einem RDS-Signale aussendenden Sender und mit mindestens einem RDS-Empfänger nach Anspruch 14.

## Claims

1. A method of phase synchronization of a bit rate clock signal (5) generated in an RDS receiver with a digital RDS signal (1) that is demodulated on the receiver side, with the bit rate clock signal (5) and the RDS signal (1) having the same bit rate,
**characterized in that**, upon switching on of the RDS receiver or upon switching over of the same to a transmitter receiving frequency different from that received so far, a control signal (RESET) is generated which, upon occurrence of the next rising edge or, alternatively, of the next falling edge of the RDS signal (1), effects such a phase angle shift of the bit rate clock signal (5) that the bit rate clock signal (5) as of then is in phase synchronism with the RDS signal (1), and
that, for generating the bit rate clock signal (5), an oscillator signal (OS) generated on the receiver side is divided down to the frequency of the bit rate clock signal (5) by means of a frequency divider counter (FT), and that the frequency divider counter (FT), upon occurrence of the next rising or falling edge of the RDS signal (1) following switching on or over of the RDS receiver, respectively, is set by the control signal (RESET) to a predetermined count at which the bit rate clock signal (5) has a rising or a falling edge, respectively, equal to that of the RDS signal (1).

2. A method according to claim 1,
**characterized in that** the edge of the RDS signal (1) at which the frequency divider counter (FT) is set to its predetermined count is synchronized with a correspondingly directed edge of the oscillator signal (OS).

3. A method according to any one of claims 1 to 2,
**characterized in that** the control signal (RESET) generated upon switching on or over of the RDS receiver is stored temporarily and is released for phase angle shift of the bit rate clock signal (5) by occurrence of the rising or falling edge of the RDS signal (1).

4. A method according to claim 3,
**characterized in that** the temporary storage of the control signal (RESET) is cancelled during the process of the phase angle shift of the bit rate clock signal (5).

5. A method according to any one of claims 1 to 4,
**characterized in that** the control signal is generated during the next falling edge of the RDS signal (1) following switching on or over, and **in that** the frequency divider counter (FT) is re set to its initial count by the control signal.

6. An apparatus for phase synchronization of a bit rate clock signal (5) generated in an RDS receiver with an RDS signal (1) demodulated on the receiver side, with the bit rate clock signal (5) and the RDS signal (1) having the same bit rate, said apparatus comprising an oscillator on the receiver side for producing an oscillator signal (OS), and a frequency divider counter (FT) having the oscillator signal (OS) fed to the input side thereof and delivering at its output the bit rate clock signal (5),
**characterized in**
**that** the frequency divider counter (FT) comprises a counter resetting input (RES) for resetting to an initial count,
**that** a control means is provided adapted to generate a control signal (RESET) upon switching on of the RDS receiver or switching over of the same to a different transmitter receiving frequency than that received so far,
**that** a temporary storage (FF2) is provided in which the control signal (RESET) can be stored temporarily and which has a temporary storage resetting input (RES) for cancelling the temporary storage contents,
and in that an edge detector (FF3) is provided which, upon occurrence of the rising or falling edge of the RDS signal (1), respectively, issues an edge detection signal (3) causing reading out of the control signal (RESET) stored in the temporary storage (FF2) and transfer thereof to the counter resetting input (RES) and to the temporary storage resetting input (RES).

7. An apparatus according to claim 6,
**characterized in that** an edge synchronization circuit (FF1) is provided having the oscillator signal (OS) and the RDS signal supplied to the input side thereof and delivering an RDS signal (1) on the output side, whose edge effecting re setting of the frequency divider counter (FT) is in synchronization with an edge of the oscillator signal (OS) having the same direction, and
**in that** the output of the edge synchronization circuit (FF1) is connected to a signal input terminal of the edge detector (FF3).

8. An apparatus according to claim 6 or 7,
**characterized in that** the edge detector (FF3) has a pulse shaping circuit (FF3, FF4) associated therewith, by means of which the output signal of the edge detector (FF3) is shaped to an edge detection pulse whose length in time is in the range of one half of the period duration of the oscillator signal (OS).

9. An apparatus according to claim 7 or 8,
**characterized in that** the edge synchronization circuit comprises a first D-type flipflop (FF1) whose D-type input receives the RDS signal, whose clock input has the oscillator signal (OS) applied thereto and whose output delivers the RDS signal (1) that is edge-synchronized with the oscillator signal (OS).

10. An apparatus according to any one of claims 6 to 9,
**characterized in that** the temporary storage comprises a second D-type flipflop (FF2) whose D-type input is on a constant logic value level, whose clock input receives the control signal (RESET) from the control means, whose resetting input forming the temporary storage resetting input has the edge detection signal of the edge detector (FF3) applied thereto and whose output delivers the control signal (RESET) from the beginning of its occurrence until receipt of the edge detection signal at the resetting input.

11. An apparatus according to any one of claims 6 to 10,
**characterized in that** the edge detector comprises a third D-type flipflop (FF3) whose D-type input is connected to the output of the second D-type flipflop (FF2), whose clock input has the RDS signal applied thereto, possibly after edge synchronization thereof with the oscillator signal (OS), and whose output is connected on the one hand to the temporary storage resetting input and on the other hand to the counter resetting input.

12. An apparatus according to any one of claims 8 to 11,
**characterized in that** the pulse shaping circuit comprises the third D-type flipflop (FF3) and a fourth D-type flipflop (FF4), with the D-type in put of the fourth D-type flipflop (FF4) being connected to the output of the third D-type flipflop (FF3), the clock input of the fourth D-type flip flop (FF4) being acted upon by the oscillator signal (OS) and the output of the fourth D-type flipflop (FF4) being connected on the one hand to the resetting input of the third flipflop (FF3) and on the other hand to the counter resetting input.

13. A bit PLL for an RDS receiver,
**characterized by** a phase synchronization apparatus according to any one of claims 6 to 12.

14. An RDS receiver,
**characterized by** a bit PLL according to claim 13.

15. An RDS radio system comprising at least one transmitter transmitting RDS signal and at least one RDS receiver according to claim 14.

## Revendications

1. Procédé pour synchroniser en phase un signal d'horloge de cadence de bits (5), produit dans un récepteur RDS, avec un signal RDS numérique (1) démodulé côté récepteur, dans lequel le signal d'horloge de cadence de bits (5) et le signal RDS (1) présentent la même cadence de bits, **caractérisé en ce que**, lors de la mise en service du récepteur RDS ou lors de sa commutation sur une fréquence de réception autre que celle reçue jusqu'alors, est produit un signal de commande (RESET), qui, lors de l'apparition du prochain flanc montant ou, à titre de variante, du prochain flanc descendant du signal RDS (1), provoque un décalage d'angle de phase du signal d'horloge de cadence de bits (5) de sorte que le signal d'horloge de cadence de bits (5) devient synchronisé en phase avec le signal RDS (1), et **en ce que**, pour l'obtention du signal d'horloge de cadence de bits (5), un signal d'oscillateur (OS) produit côté récepteur est obtenu par division de la fréquence du signal d'horloge de cadence de bits (5) au moyen d'un compteur diviseur de fréquence (FT), et **en ce que** le compteur diviseur de fréquence (FT), lors de l'apparition du prochain flanc montant, respectivement descendant, du signal RDS (1) suivant la mise en service, respectivement commutation, du récepteur RDS, est réglé par le signal de commande (RESET) à une valeur de comptage prédéterminée, le signal d'horloge de cadence de bits (5) présentant un flanc montant, respectivement descendant, identique au signal RDS (1).

2. Procédé selon la revendication 1, **caractérisé en ce que** le flanc du signal RDS (1), grâce auquel le compteur diviseur de fréquence (FT) est réglé à sa valeur de comptage prédéterminée, est synchronisé avec un flanc du signal d'oscillateur (OS) orienté de façon correspondante.

3. Procédé selon une des revendications 1 à 2, **caractérisé en ce que** le signal de commande (RESET) obtenu lors de la mise en service, respectivement commutation, du récepteur RDS est stocké de manière intermédiaire et est fourni lors de l'apparition du flanc montant, respectivement descendant, du signal RDS (1) en vue du décalage d'angle de phase du signal d'horloge de cadence de bits (5).

4. Procédé selon la revendication 3, **caractérisé en ce que** la mémorisation intermédiaire du signal de commande (RESET) est effacée lors du processus de décalage d'angle de phase du signal d'horloge de cadence de bits (5).

5. Procédé selon une des revendications 1 à 4, **caractérisé en ce que** le signal de commande est produit lors du prochain flanc descendant du signal RDS (1) suivant la mise en service ou la commutation, et **en ce que** le compteur diviseur de fréquence (FT) est remis à sa valeur de comptage initiale par le signal de commande.

6. Dispositif pour synchroniser en phase un signal d'horloge de cadence de bits (5) produit par un récepteur RDS avec un signal RDS (1) démodulé côté récepteur, dans lequel le signal d'horloge de cadence de bits (5) et le signal RDS (1) présentent la même cadence de bits, comportant un oscillateur côté récepteur pour produire un signal d'oscillateur (OS) et un compteur diviseur de fréquence (FT), auquel le signal d'oscillateur (OS) est fourni, et dont la sortie fournit le signal d'horloge de cadence de bits (5), **caractérisé en ce que** le compteur diviseur de fréquence (FT) comporte une entrée de remise à l'état initial du compteur (RES) pour remise à une valeur de comptage initiale, **en ce qu'**un dispositif de commande est prévu grâce auquel, lors de la mise en service du récepteur RDS ou de sa commutation sur une fréquence de réception autre que celle reçue jusqu'alors, un signal de commande (RESET) peut être produit, **en ce qu'**il est prévu une mémoire intermédiaire (FF2) dans laquelle le signal de commande (RESET) peut être mémorisé et qui présente une entrée de remise à l'état initial (RES) pour effacer le contenu de la mémoire intermédiaire, et **en ce qu'**il est prévu un détecteur de flancs (FF3), qui, lors de l'apparition du flanc montant, respectivement descendant, du signal RDS (1) fournit un signal de détection de flanc (3) qui provoque une lecture du signal de commande (RESET) stocké dans la mémoire intermédiaire (FF2) et sa transmission à l'entrée de remise à l'état initial du compteur (RES) et à l'entrée de remise à l'état initial de la mémoire intermédiaire (RES).

7. Dispositif selon la revendication 6, **caractérisé en ce qu'**il est prévu un circuit de synchronisation de flancs (FF1), auquel sont fournis le signal d'oscillateur (OS) et le signal RDS, et fournissant en sortie un signal RDS (1) dont le flanc servant à remettre à l'état initial le compteur diviseur de fréquence (FT) est synchronisé avec un flanc de même orientation du signal d'oscillateur (OS), et **en ce que** la sortie du circuit de synchronisation de flancs (FF1) est couplée à une borne d'entrée de signal du détecteur de flancs (FF3).

8. Dispositif selon la revendication 6 ou 7, **caractérisé en ce qu'**un circuit de formation d'impulsions (FF3, FF4) est associé au détecteur de flancs (FF3), au moyen duquel le signal de sortie du détecteur de flancs (FF3) est transformé en une impulsion de détection de flanc dont la longueur temporelle correspond environ à la demi-période du signal d'oscillateur (OS).

9. Dispositif selon la revendication 7 ou 8, **caractérisé en ce que** le circuit de synchronisation de flancs comprend une première bascule D (FF1), dont l'entrée D reçoit le signal RDS, dont l'entrée d'horloge reçoit le signal d'oscillateur (OS) et dont la sortie fournit le signal RDS (1) de flancs synchronisés au signal d'oscillateur (OS).

10. Procédé selon une des revendications 6 à 9, **caractérisé en ce que** la mémoire intermédiaire comporte une deuxième bascule D (FF2), dont l'entrée D se trouve à un niveau logique constant, dont l'entrée d'horloge reçoit le signal de commande (RESET) du dispositif de commande, dont l'entrée de remise à zéro formant l'entrée de remise à l'état initial de la mémoire intermédiaire reçoit le signal de détection de flanc du détecteur de flancs (FF3) et à la sortie de laquelle se trouve le signal de commande (RESET), depuis le début de son apparition jusqu'à l'apparition du signal de détection de flanc à l'entrée de réinitialisation.

11. Dispositif selon une des revendications 6 à 10, **caractérisé en ce que** le détecteur de flancs comporte une troisième bascule D (FF3), dont l'entrée D est reliée à la sortie de la deuxième bascule D (FF2), dont l'entrée d'horloge reçoit le signal RDS, le cas échéant après sa synchronisation de flancs avec le signal d'oscillateur (OS), et dont la sortie est reliée d'une part à l'entrée de remise à l'état initial de la mémoire intermédiaire et d'autre part à l'entrée de remise à l'état initial du compteur.

12. Dispositif selon une des revendications 8 à 11, **caractérisé en ce que** le circuit de formation d'impulsions comporte la troisième bascule D (FF3) et une quatrième bascule D (FF4), l'entrée D de la quatrième bascule D (FF4) étant reliée à la sortie de la troisième bascule D (FF3), l'entrée d'horloge de la quatrième bascule D (FF4) recevant le signal d'oscillateur (OS) et la sortie de la quatrième bascule D (FF4) étant reliée d'une part à l'entrée de remise à zéro de la troisième bascule D (FF3) et d'autre part à l'entrée de remise à l'état initial du compteur.

13. Boucle à verrouillage de phase (PLL) numérique pour récepteur RDS, **caractérisée par** un dispositif de synchronisation de phase selon une des revendications 6 à 12.

14. Récepteur RDS, **caractérisé par** une PLL numérique selon la revendication 13.

15. Système radio RDS comportant au moins un émetteur diffusant un signal RDS et au moins un récepteur RDS selon la revendication 14.
